**Europäisches Patentamt**

**European Patent Office**

**Office européen des brevets**

(11) Veröffentlichungsnummer: **0 384 937**
**A1**

## (12) EUROPÄISCHE PATENTANMELDUNG

(21) Anmeldenummer: **89103799.6**

(22) Anmeldetag: **03.03.89**

(51) Int. Cl.⁵: **H03K 17/08, H02H 9/02**

(43) Veröffentlichungstag der Anmeldung:
**05.09.90 Patentblatt 90/36**

(84) Benannte Vertragsstaaten:
**AT BE CH DE ES FR GB GR IT LI LU NL SE**

(71) Anmelder: **Siemens Aktiengesellschaft**
**Wittelsbacherplatz 2**
**D-8000 München 2(DE)**

(72) Erfinder: **Tihanyi, Jenö, Dr.**
**Windeckstrasse 1 d**
**D-8000 München 70(DE)**

(54) Schutzschaltung für einen Leistungs-MOSFET.

(57) Beim Kurzschluß der mit einem Leistungs-MOS-FET (1) in Reihe liegenden Last (4) steigt die Drain-Sourcespannung des Leistungs-MOSFET (1) an. Liegt die $U_{DS}$ über einem vorgegebenen Wert, wird die Gate-Sourcespannung des Leistungs-MOSFET (1) auf einen niedrigeren Wert eingestellt. Dem entspricht eine niedrigere im Leistungs-MOSFET (1) umgesetzte Verlustleistung.

# FIG 2

EP 0 384 937 A1

## Schutzschaltung für einen Leistungs-MOSFET

Die Erfindung betrifft eine Schaltungsanordnung zum Schutz eines Leistungs-MOSFET beim Kurzschluß seiner Last.

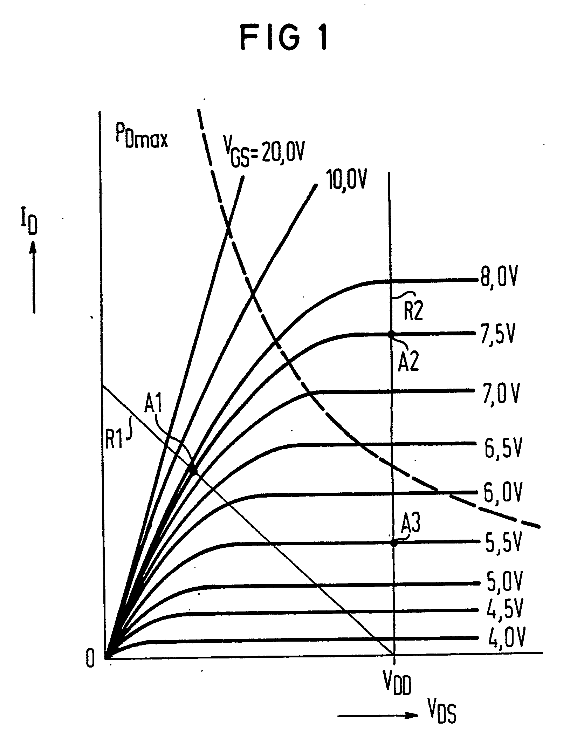

Leistungs-MOSFET werden im Kennlinienfeld Drainstrom $I_D$/ Drain-Sourcespannung $V_{DS}$ mit der Gate-Sourcespannung $V_{GS}$ als Parameter unterhalb der maximalen Verlustleistung $P_{Dmax}$ betrieben (FIG 1). Eine ohmsche Last stellt sich hier als Widerstandsgrade R1 dar. Sie fußt auf der Abszisse bei der Versorgungsspannung $V_{DD}$ und hat eine ihrem Widerstand entsprechende Steigung. Bei einem Kurzschluß der Last wird der Widerstand nahezu Null. Dies wird durch die senkrechte Gerade R2 im Kennlinienfeld symbolisiert. Der Arbeitspunkt A1 wird zum Arbeitspunkt A2, der oberhalb der Impulsverlustleistungshyperbel $P_{Dmax}$ liegt. Damit wird im Leistungs-MOSFET eine unzulässig hohe Verlustleistung umgesetzt, die ohne Gegenmaßnahmen zu einer sicheren Zerstörung des Leistungs-MOSFET führt.

Die Erfindung hat das Ziel, eine einfache Schaltungsanordnung anzugeben, mit der ein Leistungs-MOSFET beim Kurzschluß seiner Last geschützt werden kann.

Dieses Ziel wird erreicht durch Mittel, die die Gate-Sourcespannung des Leistungs-MOSFET auf einen niedrigeren Wert einstellen, wenn seine Drain-Sourcespannung über einem vorgegebenen Wert liegt.

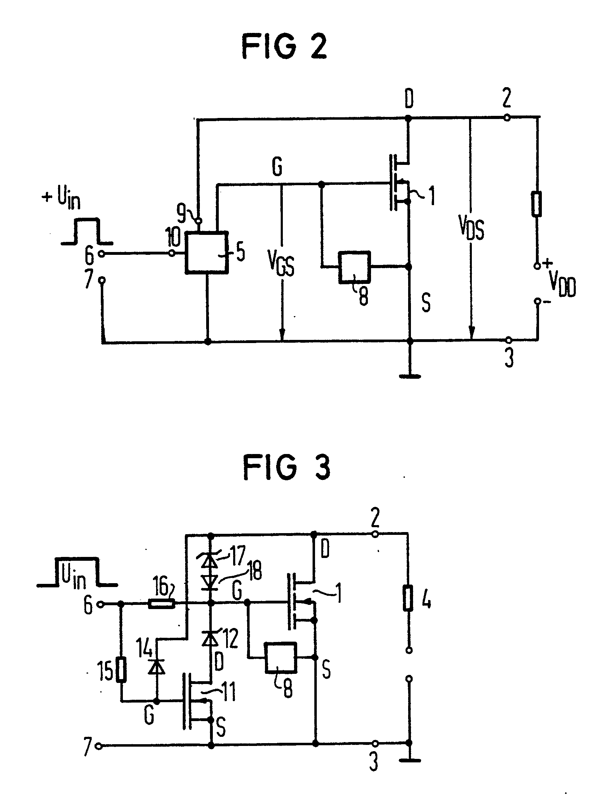

Die Erfindung wird anhand zweier Ausführungsbeispiele in Verbindung mit den FIG 2 und 3 näher erläutert. Diese Figuren zeigen ein allgemeines bzw. spezielles Ausführungsbeispiel der Erfindung.

Die Schaltungsanordnung nach FIG 2 enthält einen n-Kanal LeistungsMOSFET 1, dessen Drainanschluß D über eine Klemme 2 mit einer Last 4 und dessen Sourceanschluß S über eine Klemme 3 mit einer Spannungsquelle $V_{DD}$ verbunden ist. Ein Anschluß der Last 4 liegt ebenfalls an $V_{DD}$. Zwischen dem Gateanschluß G und dem Sourceanschluß S von 1 liegen Mittel 5, die die Gate-Sourcespannung $V_{GS}$ auf einen niedrigeren Wert als die an den Eingangsklemmen 6, 7 liegende Steuerspannung $U_{in}$ einstellen, wenn die Drain-Sourcespannung $V_{GS}$ am Leistungs-MOSFET 1 einen bestimmten Wert übersteigt. Dazu haben die Mittel 5 einen Eingang 9, der mit dem Drainanschluß D von 1 verbunden ist. Sie haben einen weiteren Eingang 10, der mit einer Eingangsklemme 6 verbunden ist.

Wird an die Eingangsklemmen 6, 7 eine Steuerspannung $U_{in}$ angelegt, so wird der Leistungs-MOSFET 1 eingeschaltet und durch die Last 4 fließt ein Laststrom. Beträgt die Gate-Sourcespannung z. B. 7,5 Volt (siehe FIG 1), so stellt sich der Arbeitspunkt A1 ein, der unterhalb der Verlusthyperbel liegt. Bei einem Kurzschluß über der Last 4 steigt die Drain-Sourcespannung $V_{DS}$ ungefähr auf den Wert der Versorgungsspannung $V_{DD}$ an. Dieser Spannungsanstieg wird über den Eingang 9 von den Mitteln 5 detektiert. Daraufhin wird $V_{GS}$ auf einen gegenüber der Steuerspannung niedrigeren Wert von z. B. 5,5 V eingestellt, der so bemessen ist, daß der Arbeitspunkt nunmehr unterhalb der maximal zulässigen Verlustleistung liegt. In FIG 1 ist dieser Arbeitspunkt mit A3 bezeichnet.

Die in FIG 2 schematisch dargestellten Mittel 5 lassen sich einfach realisieren, wie anhand von FIG 3 erläutert. Sie bestehen aus einem Transistor 11, der ein MOSFET, ein Bipolartransistor oder auch ein IGBT (Isolated Gate Bipolar Transistor) sein kann. Wird ein MOSFET verwendet, so ist mit seinem Drainanschluß D eine Zenerdiode 12 verbunden. Die Reihenschaltung aus 11 und 12 liegt zwischen dem Gateanschluß G und dem Sourceanschluß S des Leistungs-MOSFET 1. Der Gateanschluß G von 11 liegt über einen Widerstand 15 an der Eingangsklemme 6. Mit dem Gateanschluß G ist eine Diode 14 verbunden, deren anderer Anschluß mit dem Drainanschluß von 1 verbunden ist.

Fließt der Laststrom durch die Last 4, so ist das Anodenpotential der Diode 14 niedrig und der über den Widerstand 15 von der Klemme 6 gelieferte Teil des Steuerstroms fließt durch die Diode 14 zum Drainanschluß von 1 ab. Der Transistor 11 bleibt damit gesperrt und am Gateanschluß von 1 liegt als Gate-Sourcespannung im wesentlichen die volle Steuerspannung an. Der Leistungs-MOSFET 1 wird damit im Arbeitspunkt A1, d. h. in einem Bereich relativ geringem Durchlaßwiderstandes mit niedrigen Verlusten betrieben.

Im Kurzschlußfall steigt die Spannung am Drainanschluß von 1 und damit an der Anode der Diode 14 an und die Diode 14 wird gesperrt. Damit wird der Transistor 11 leitend gesteuert und die Gate-Sourcespannung von 1 wird auf eine Spannung begrenzt, die sich aus der Summe der Zenerspannung der Zenerdiode 12 und der am Transistor 11 abfallenden Spannung ergibt. Liegt diese Spannung z. B. bei 5,5 Volt, so stellt sich der Arbeitspunkt A3 (FIG 1) ein.

Bei Verwendung einer einen hohen Gatestrom für den LeistungsMOSFET 1 liefernden Treiberschaltung ist in die Gateleitung von 1 ein den Gatestrom begrenzender Widerstand 16 eingeschaltet. Dieser liegt zwischen dem Anodenanschluß der Zenerdiode 12 und dem Verbindungspunkt zwischen Eingangsklemme 6 und Widerstand 15.

Ist die Last 4 induktiv, so empfiehlt es sich, zum Schutz der Gate-Drainkapazität des Leistungs-MOSFET 1 zwischen den Gateanschluß und den Drainanschluß die Reihenschaltung aus einer weiteren Zenerdiode 17 und einer Diode 18 zu legen. Die Diode 18 ist dabei so gepolt, daß der Steuerstrom für 1 nicht zum Drainanschluß abfließen kann. Die Zenerdiode 17 ist so gepolt, daß sie durchbricht, wenn das Drainpotential um ihre Zenerspannung höher als das Gatepotential von 1 ist.

Die Erfindung läßt sich besonders vorteilhaft bei Leistungs-MOSFET anwenden, die mit einem Temperatursensor, z. B. einen integrierten Temperatursensor aufweisen. Dieser ist entweder auf dem Chip des Leistungs-MOSFET oder am Gehäuse angebracht und ist mit dem Gateanschluß G und den Sourceanschluß S verbunden. Er enthält z. B. einen Halbleiterkörper mit vier Schichten abwechselnden Leitungstyps, der bei Überschreiten einer bestimmten Spannung in den leitenden Zustand schaltet. Damit wird die Gate-Sourcekapazität von 1 entladen und der Leistungs-MOSFET wird gesperrt. Da der Temperatursensor jedoch relativ träge arbeitet, kann er im allgemeinen den Leistungs-MOSFET beim Kurzschluß einer Last alleine nicht wirksam schützen. In Kombination mit der Herabsetzung der Gate-Sourcespannung ist ein wirksamer Schutz des Leistungs-MOSFET beim Kurzschluß seiner Last möglich. Beim Kurzschluß wird zuerst die Gate-Sourcespannung herabgesetzt und der Leistungs-MOSFET mit niedrigerem Strom als den Nennstrom betrieben. Bei weiterer Erwärmung wird er dann durch den Temperatursensor völlig abgeschaltet.

**Ansprüche**

1. Schaltungsanordnung zum Schutz eines Leistungs-MOSFET beim Kurzschluß seiner Last, **gekennzeichnet durch** Mittel (5), die die Gate Sourcespannung des Leistungs-MOSFET (1) auf einen niedrigeren Wert als die Eingangsspannung ($U_{in}$) einstellen, wenn seine Drain-Sourcespannung über einem vorgegebenem Wert liegt.

2. Schaltungsanordnung nach Anspruch 1, **dadurch gekennzeichnet,** daß die Mittel (5) die Reihenschaltung aus einer Zenerdiode (12) und einem Transistor (11) enthalten, daß diese Reihenschaltung zwischen Gateanschluß (G) und Sourceanschluß (S) des Leistungs-MOSFET (1) angeschlossen ist, daß der Steueranschluß des Transistors (11) einerseits über einen Widerstand (15) mit einer Steuereingangsklemme (6) und andererseits über eine Diode (14) mit dem Drainanschluß (D) des Leistungs-MOSFET (1) verbunden ist.

3. Schaltungsanordnung nach Anspruch 1 oder 2, **dadurch gekennzeichnet,** daß zwischen Drainanschluß und Gateanschluß des Leistungs-MOSFET (1) die Reihenschaltung aus einer Diode (18) und einer weiteren Zenerdiode (17) angeschlossen ist, wobei die Anodenanschlüsse der genannten Dioden miteinander verbunden sind.

4. Schaltungsanordnung nach Anspruch 1, **dadurch gekennzeichnet,** daß der Leistungs-MOSFET (1) einen Temperatursensor (8) aufweist, der dessen Gateanschluß elektrisch mit dessen Sourceanschluß verbindet, wenn eine vorgegebene Temperatur erreicht wird.

5. Schaltungsanordnung nach Anspruch 3, **dadurch gekennzeichnet,** daß in der Gateleitung des Leistungs-MOSFET (1) zwischen Eingangsklemme (6) und Katodenanschluß der Zenerdiode (12) ein Widerstand (16) liegt und daß dieser Widerstand niederohmiger als der in der Steuerleitung des Transistors (11) liegende Widerstand (15) ist.

6. Schaltungsanordnung nach Anspruch 2, **dadurch gekennzeichnet,** daß der Transistor (11) ein MOSFET ist.

# FIG 1

## FIG 2

## FIG 3

## EINSCHLÄGIGE DOKUMENTE

| Kategorie | Kennzeichnung des Dokuments mit Angabe, soweit erforderlich, der maßgeblichen Teile | Betrifft Anspruch | KLASSIFIKATION DER ANMELDUNG (Int. Cl.5) |
|---|---|---|---|
| X | ELEKTROTECHNIK UND INFORMATIONSTECHNIK. vol. 105, no. 4, April 1988, WIEN AT Seiten 158 - 162; O.Hintringer: "Intelligente MOS-Leistungsschalter in der Automobilelektronik" * Seite 160, Absatz 4.1; Figuren 3, 4 * | 1 | H 03 K 17/08 H 02 H 9/02 |
| Y | NEW ELECTRONICS.INCORPORATING ELECTRONICS TODAY. vol. 16, no. 19, November 1983, LONDON GB Seiten 67 - 73; P.E.V.Phillips: "Automotive load switching" * Seite 71; Figur 2d * | 2, 3, 6 | |
| Y | DE-A-3 034 927 (SIEMENS) * Seite 5, Zeile 12 - Seite 6, Zeile 7; Figur 1 * | 2, 6 | |
| Y | SIEMENS FORSCHUNGS- UND ENTWICKLUNGSBERICHTE. vol. 14, no. 2, 1985, BERLIN DE Seiten 56 - 61; J.Tihanyi: "Protection of power MOSFETs from transient overvoltages" * Figuren 6, 8 * | 3 | |
| A | PATENT ABSTRACTS OF JAPAN vol. 11, no. 113 (E-497)(2560) 9 April 1987, & JP-A-61 261920 (TOSHIBA) 20 November 1986, * das ganze Dokument * | | RECHERCHIERTE SACHGEBIETE (Int. Cl.5) H 02 H 9/02 H 02 H 9/04 H 03 K 17/08 |
| A | DE-A-3 430 961 (SIEMENS) * Figuren 1, 2 * | | |

Der vorliegende Recherchenbericht wurde für alle Patentansprüche erstellt

| Recherchenort | Abschlußdatum der Recherche | Prüfer |
|---|---|---|
| BERLIN | 19-10-1989 | LEMMERICH J |